Europäisches Patentamt

European Patent Office

Office européen des brevets

(11) Numéro de publication: **0 433 970 A1**

## (12) DEMANDE DE BREVET EUROPEEN

(21) Numéro de dépôt: **90124568.8**

(22) Date de dépôt: **18.12.90**

(51) Int. Cl.⁵: **G01R 15/06, H01G 4/02**

(30) Priorité: **19.12.89 FR 8916815**

(43) Date de publication de la demande:
**26.06.91 Bulletin 91/26**

(84) Etats contractants désignés:
**AT BE CH DE DK ES FR GB GR IT LI LU NL SE**

(71) Demandeur: **GEC ALSTHOM SA**
**38, avenue Kléber**
**F-75116 Paris(FR)**

(72) Inventeur: **Dupraz, Jean-Pierre**
**7, rue Moissonier**
**F-69003 Lyon(FR)**

(74) Mandataire: **Weinmiller, Jürgen et al**
**Lennéstrasse 9 Postfach 24**
**W-8133 Feldafing(DE)**

(54) **Capteur capacitif pour dispositif de mesure du potentiel d'un conducteur de ligne, dans un poste blindé.**

(57) La présente invention concerne un capteur capacitif composé de deux condensateurs concentriques ayant une électrode commune (11), un condensateur haute tension et un condensateur auxiliaire, et comportant deux écrans (14, 15) séparant les deux électrodes (10, 11) du condensateur haute tension, ces deux écrans laissant subsister entre eux une fenêtre de hauteur invariable.

FIG.1

EP 0 433 970 A1

## CAPTEUR CAPACITIF POUR DISPOSITIF DE MESURE DU POTENTIEL D'UN CONDUCTEUR DE LIGNE, DANS UN POSTE BLINDÉ.

La présente invention concerne un capteur capacitif pour dispositif de mesure du potentiel d'un conducteur de ligne, comportant deux condensateurs ayant une électrode commune, ces deux condensateurs étant l'un un condensateur haute tension dont la deuxième électrode est constituée par le conducteur de ligne, et l'autre un condensateur auxiliaire dont la deuxième électrode est reliée à la terre, l'électrode commune recevant un câble de liaison relié au dispositif de mesure

On connaît de tels capteurs dont l'électrode commune est un tube métallique entourant le conducteur de ligne, la deuxième électrode du condensateur auxiliaire étant un autre tube de plus grand diamètre séparé du premier tube par une couche diélectrique.

Dans de tels capteurs, la capacité du condensateur haute tension n'est pas stable si la température ambiante varie. En effet, la longueur du tube, constituant l'électrode commune, varie en fonction de la température, ce qui perturbe la mesure du potentiel du conducteur de ligne, au-delà de la marge d'erreur tolérée qui est de 0,2 % environ.

La présente invention a pour but de concevoir un capteur capacitif dont le condensateur haute-tension est d'une grande stabilité.

Ce but est atteint par l'adjonction de deux écrans qui laissent subsister, entre eux, une fenêtre de hauteur constante quelle que soit la température.

La présente invention a pour objet un capteur capacitif pour dispositif de mesure du potentiel d'un conducteur de ligne, comportant deux condensateurs ayant une électrode commune, ces deux condensateurs étant l'un un condensateur haute tension dont la deuxième électrode est constituée par le conducteur de ligne, et l'autre un condensateur auxiliaire dont la deuxième électrode est reliée à la terre, l'électrode commune recevant un câble de liaison relié au dispositif de mesure, les électrodes du condensateur haute tension étant séparées par deux écrans qui laissent subsister entre eux une fenêtre de hauteur invariable, capteur caractérisé en ce que les deux écrans sont reliés par des cales en invar qui assure l'invariabilité de la hauteur de la fenêtre.

Selon un mode de réalisation préféré, les écrans sont réalisés à partir d'un cylindre unique en invar dans lequel ont été découpées des fenêtres de dimensions appropriées.

Il est décrit ci-après, à titre d'exemple et en référence aux dessins annexés, un capteur capacitif selon l'invention.

La figure 1 montre un premier mode de réalisation du capteur capacitif selon l'invention, ce capteur étant installé à l'extrémité d'un conducteur.

La figure 2 montre une variante de ce premier mode de réalisation.

La figure 3 montre un deuxième mode de réalisation du capteur capacitif selon l'invention, ce capteur étant également installé à l'extrémité d'un conducteur.

La figure 4 montre un capteur selon le deuxième mode de réalisation, ce capteur étant installé le long d'un conducteur.

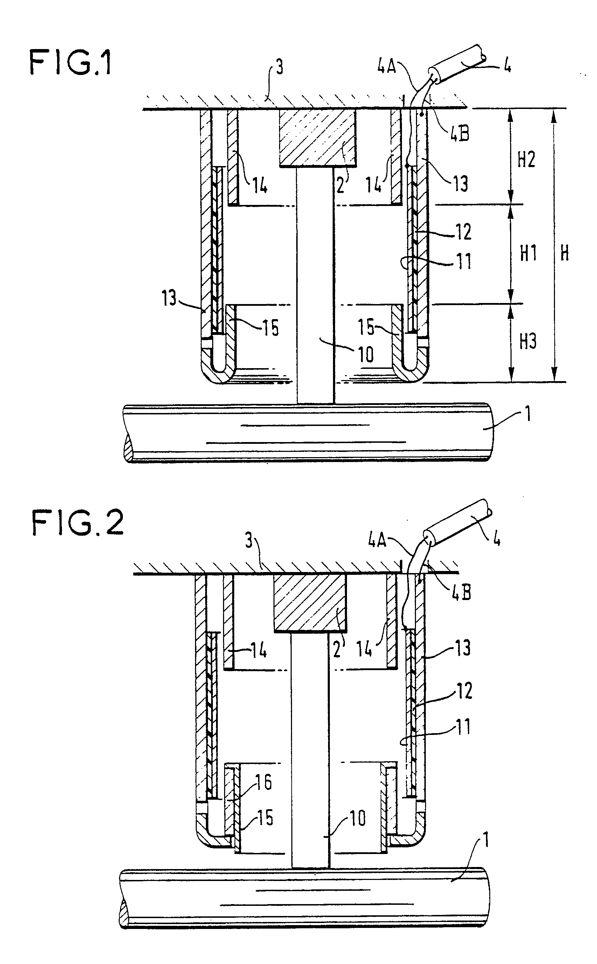

Dans la figure 1, le capteur capacitif comporte deux condensateurs, un premier condensateur $C_1$ haute tension constitué entre un conducteur de ligne 10 et une électrode 11, et un deuxième condensateur $C_2$ constitué entre l'électrode 11 et une électrode externe 13. L'électrode commune 11 et l'électrode 13 sont séparées par une couche diélectrique 12.

L'ensemble constitué par l'électrode 11 et la couche 12, est en fait formé d'un film métallisé collé sur l'électrode 13 L'électrode 11 constitue la partie métallique et la couche 12 constitue le support du film, son épaisseur étant d'environ 1 mm.

Le conducteur de ligne 10 (électrode 10) est relié, par une extrémité, à un jeu de barres 1 d'un poste blindé haute tension, et, par l'autre extrémité, à un isolateur 2 monté sur une enveloppe 3 du poste blindé rempli d'un gaz tel que l'hexafluorure de soufre SF6. L'enveloppe 3 et l'électrode 13 sont au même potentiel "0".

Un câble électrique 4, qui assure la liaison entre le capteur capacitif et le dispositif de mesure installé à l'extérieur du poste blindé, est connecté à l'électrode commune 11 par l'intermédiaire d'un fil 4A, tandis que son fil de masse 4B est relié au potentiel "0".

L'enveloppe 3 comporte une traversée étanche (non représentée) assurant le passage du câble 4.

Un écran, composé de deux parties cylindriques 14 et 15, est intercalé entre le conducteur 10 et l'électrode commune 11. La partie 14 est reliée à l'enveloppe 3 du poste blindé et la partie 15 est reliée à l'électrode 13. Entre ces deux parties, l'espace libre a une hauteur appellée $H_1$, $H_2$ étant la hauteur de la partie 14, $H_3$ la hauteur de la partie 15, et H la hauteur totale.

La capacité du condensateur $C_1$ est donné par la relation :

$$C_1 = 2\pi \varepsilon_0 \varepsilon_r \frac{H_1}{1_n \frac{D}{d}}$$

avec D : diamètre intérieure de l'électrode 11

d : diamètre du conducteur 10

$\varepsilon_r$: permittivité relative du gaz SF6.(fonction de sa densit

Si le conducteur 10 et l'électrode 11 sont réalisées dans le même matériau, leur diamètre vont varier mais le coéfficient D/d restera constant. Pour que la capacité de $C_1$ reste constante, il faut donc que H1 reste constante quelle que soit la température.

Il faut aussi que εr reste constant, mais pour remplir cette condition, on utilise un densimètre qui permet de réaliser soit une régulation de la densité par compensation des fuites, soit une correction électronique des dérives de εr. Dans ce dernier cas, on utilise un densimètre pour mesurer la densité, mais on peut aussi mesurer la pression et la température du gaz.

Concernant la hauteur $H_1$, on a la relation $H_1 = H - H_2 - H_3$

avec

$H = H_0 (1 + \alpha t)$

$H_2 = H_{20} (1 + \alpha_2 t)$

$H_3 = H_{30} (1 + \alpha_3 t)$

t étant la température ambiante; $\alpha$ le coéfficient de dilatation du conducteur 10 et des électrodes 11 et 13; $\alpha_2$ le coéfficient de dilatation de la partie 14 (hauteur H2); $\alpha_3$ le coéfficient de dilatation de la partie 15 (hauteur H3)

$H_1 = H_0 - H_{20} - H_{30} + (H_0\alpha - H_{20} \alpha_2 - H_{30}\alpha_3)t$

Pour que la hauteur $H_1$ soit indépendante de la température, il suffit donc de choisir les hauteurs $H_0$, $H_{20}$, $H_{30}$ et les coéfficients $\alpha$, $\alpha_2$, $\alpha_3$, de manière que la relation

$H_0\alpha - H_{20}\alpha_2 - H_{30}\alpha_3 = 0$

Dans un exemple plus simple, toutes les parties 10, 11, 13, 14 sont fabriquées dans un seul et même matériau à coéfficient $\alpha$ et la partie 15 est fabriquée dans un matériau de coéfficient $\alpha_3$ Dans ce cas on a la relation :

$H_0\alpha - H_{20}\alpha - H_{30}\alpha_3 = 0$

$(H_0 - H_{30})\alpha - H_{30}\alpha 3 = 0$

donc il faut choisir $\alpha_3$ tel que

$$\alpha_3 = \frac{H_0 - H_{20}}{H_{30}}\alpha$$

La figure 2 représente une variante de réalisation, dans laquelle la partie 15 est fabriquée dans un matériau de coéfficient $\alpha$ mais elle est montée sur un support 16 fabriqué dans un matériau de coéfficient de dilatation $\alpha_3$.

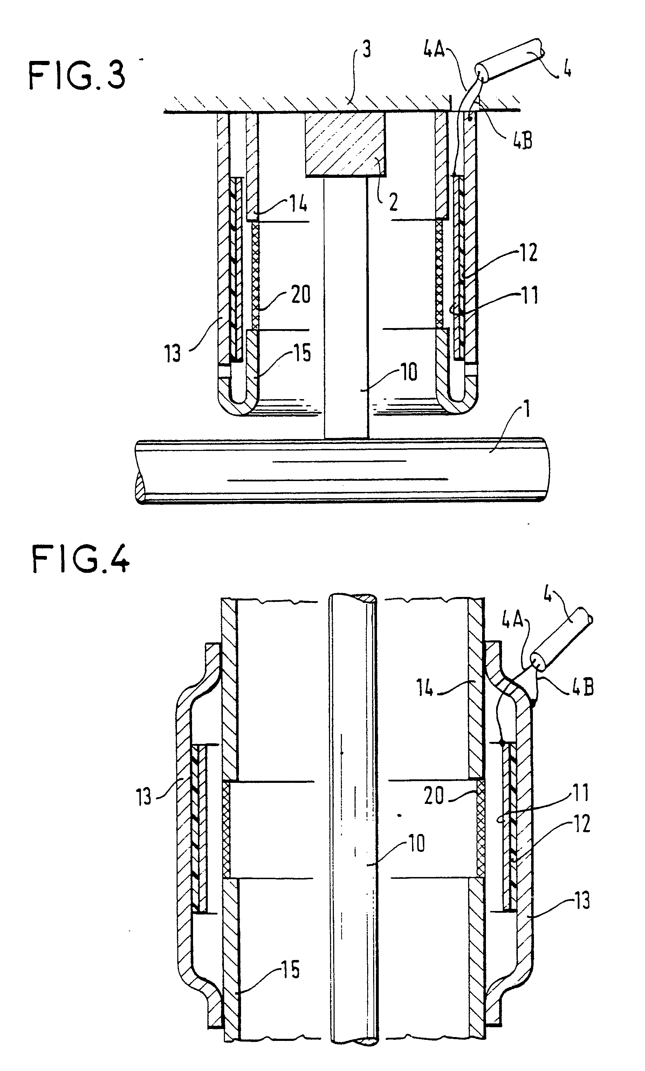

Dans la figure 3, le capteur capacitif comporte des cales 20 en invar, qui maintiennent constante la hauteur de la fenêtre constituée entre les écrans 14 et 15. Ces cales peuvent être constituées de simples tiges réparties sur la circonférence ou elles peuvent constituer, avec les deux supports, un cylindre unique, ajouré au niveau de la fenêtre, et avec toutes les formes possibles, en grillage par exemple.

Dans la figure 4, le capteur est installé le long d'un conducteur, et la fenêtre séparant le conducteur (ou électrode) 10 et l'électrode 11 comporte des cales 20 en invar qui maintiennent constante la hauteur de la fenêtre.

**Revendications**

1. Capteur capacitif pour dispositif de mesure du potentiel d'un conducteur de ligne, comportant deux condensateurs ayant une électrode commune (11), ces deux condensateurs étant l'un un condensateur haute tension dont la deuxième électrode (10) est constituée par le conducteur de ligne (10), et l'autre un condensateur auxiliaire dont la deuxième électrode (13) est reliée à la terre, l'électrode commune (11) recevant un câble de liaison (4) relié au dispositif de mesure les électrodes (10, 11) du condensateur haute tension étant séparées par deux écrans (14, 15) qui laissent subsister entre eux une fenêtre de hauteur invariable, capteur caractérisé en ce que la fenêtre comporte des cales (20) en invar, qui lui assure une hauteur constante.

2. Capteur capacitif selon la revendication 1, caractérisé en ce que les écrans (14, 15) sont réalisés à partir d'un cylindre unique en invar dans lequel ont été découpées des fenêtres de dimensions appropriées.

3. Capteur selon la revendication 1 ou 2, baignant dans un gaz diélectrique, caractérisé en ce que la permittivité relative du gaz est maintenue constante par compensation des fuites.

4. Capteur selon la revendication 1 ou 2, baignant dans un gaz diélectrique, caractérisé en ce que l'on corrige électroniquement ses variations de capacité dues aux variations de la permittivité relative du gaz.

4

FIG.1

FIG.2

EP 0 433 970 A1

# FIG.3

# FIG.4

6

Office européen
des brevets

**RAPPORT DE RECHERCHE
EUROPEENNE**

Numéro de la demande

**EP 90 12 4568**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | DE-A-2 641 574  (SIEMENS AG)<br>* le document en entier *<br>— — — | 1 | G 01 R<br>15/06<br>H 01 G 4/02 |
| Y | DE-B-1 942 088  (N.V.COQ)<br>* le document en entier *<br>— — — | 2 | |
| Y | DE-B-1 175 890  (THE INTERNATIONAL NICKEL COMP.)<br>* colonne 1, ligne 1 - colonne 1, ligne 15 *<br>— — — | 1,2 | |
| A | DE-A-2 827 406  (FRITZ DRIESCHER SPEZIALFABRIK FÜR ELEKRIZITÄTSWERKSBEDARF)<br>* revendications 1, 5, 6; figures 1, 2 *<br>— — — | 3,4 | |
| A | US-A-4 167 770  (H.W.GRAYBILL)<br>* colonne 1, ligne 20 - colonne 1, ligne 32; figure 3 *<br>— — — — — | | |

| | DOMAINES TECHNIQUES RECHERCHES (Int. Cl.5) |
|---|---|
| | G 01 R<br>H 01 F<br>H 01 G<br>H 02<br>B<br>C 22 C |

Le présent rapport de recherche a été établi pour toutes les revendications

| Lieu de la recherche | Date d'achèvement de la recherche | Examinateur |
|---|---|---|
| Berlin | 07 mars 91 | LEMMERICH J |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire
T : théorie ou principe à la base de l'invention

E : document de brevet antérieur, mais publié à la date de dépôt ou après cette date
D : cité dans la demande
L : cité pour d'autres raisons

& : membre de la même famille, document correspondant